# EUROPÄISCHE PATENTSCHRIFT

(11) **EP 4 210 540 B1**
(45) Veröffentlichungstag und Bekanntmachung des Hinweises auf die Patenterteilung: **29.05.2024**
(21) Anmeldenummer: 21770118.4
(22) Anmeldetag: 01.09.2021
(51) Int. Cl.: A47B 21/06, A47B 88/919, H05K 7/14

(54) **VORRICHTUNG ZUR FÜHRUNG EINES STROMKABELS**
CABLE MANAGEMENT DEVICE
SYSTEME DE GUIDAGE DE CÂBLES

(30) Priorität: 08.09.2020 AT 602792020; 19.05.2021 AT 503902021
(43) Veröffentlichungstag der Anmeldung: 19.07.2023
(73) Patentinhaber: Julius Blum GmbH, 6973 Höchst (AT)
(72) Erfinder: BALIKO, Karl, 6812 Meiningen (AT)
(74) Vertreter: Torggler & Hofmann Patentanwälte - Innsbruck
(86) Internationale Anmeldenummer: PCT/AT2021/060304
(87) Internationale Veröffentlichungsnummer: WO 2022/051786

(56) Entgegenhaltungen:
- JP-A- 2018 038 246
- US-A- 4 614 383
- US-A1- 2004 003 543
- US-A1- 2016 238 159
- US-A1- 2018 035 564
- US-A1- 2018 112 739
- US-B1- 9 070 419

## Beschreibung

Die Erfindung betrifft eine Vorrichtung zur Führung eines Stromkabels entlang einer Bewegungsrichtung eines einer Schublade gleichenden Ausziehelementes sowie ein Möbel mit wenigstens einem einer Schublade gleichenden Ausziehelement und wenigstens einer Vorrichtung zur Führung eines Stromkabels entlang einer Bewegungsrichtung des Ausziehelementes.

Elektrische Geräte werden vielfach in Schubladen verstaut. Nicht selten ist deren Verwendung von sehr kurzer Dauer und gleichzeitig die Nutzungsstelle nahe der Schublade. Es wäre also für den Anwender bequem, wenn das Gerät bereits in der Schublade an einer Stromversorgung angeschlossen wäre und nach dem Gebrauch eine Trennung von der Steckdose nicht erforderlich ist. Ein Haartrockner kann derart verwendet werden. Ausziehtablare ähneln in ihrer technischen Ausgestaltung den Möbelschubladen. Ihnen fehlt lediglich die senkrechte Umrandung. Solche Ausziehfächer sind ideal für eine Vielzahl von teils schweren Küchenmaschinen. Solche Geräte werden für die Verwendung nur aus dem Schrank gezogen aber nicht vom Tablar entnommen. Beispielgebend genannt seien hier Wasserkocher, Mixer, Toaster, und Kaffeemaschinen. All diesen Anwendungen ist gemein, dass es bequem wäre, wenn sich der Benutzer nicht jedes Mal um deren elektrische Versorgung kümmern muss.

Geräte mit geringem Stromverbrauch können auch von Stromspeichern, welche die Bewegung der Schublade mitvollziehen, versorgt werden. Die DE 20 2019 101 563 U1 befasst sich mit einer elektrischen Schubladenbeleuchtung, die auf einen derartigen Energiespeicher aufbaut.

Das Kernthema der DE 1 944 858 U ist die Gestaltung einer Kabelführung, die der Bewegung der Schublade folgt. Der erhebliche Stauraumverlust im hinteren Bereich der Schublade erweist sich bei dieser Ausgestaltung als besonders nachteilig. Vermutlich ist im beschriebenen Fall auch für die Montage der Kabelführung eine Zugangsmöglichkeit hinter der Schublade erforderlich.

Früher waren in der Regel Schubladenführungen an der Außenseite der Schublade platziert. Aus optischen Gründen wurden in den vergangenen Jahrzehnten ein großer Teil der Schubladenführungen unter die Schublade verlegt. Dies bedeutet, dass unter der Schublade ein Bauraum entstanden ist, der dem Nutzer in keinem Falle als Stauraum zur Verfügung steht. Moderne Beschlagsysteme nützen diesen Bereich für die Platzierung von Funktionselementen wie Auswurfmechaniken oder Parallellaufgestänge und vieles mehr.

Kabelführungen für lineare Bewegungen sind aus dem Maschinenbau, wie zum Beispiel aus den Patentdokumenten US2017250509A1, JP2018038246A und US2016238159A1 bekannt und weit verbreitet. Die Erfindung befasst sich nicht primär mit diesem Thema.

Der Erfindung liegt die Aufgabe zugrunde, eine gegenüber dem Stand der Technik verbesserte Vorrichtung zur Führung eines Stromkabels entlang einer Bewegungsrichtung eines einer Schublade gleichenden Ausziehelementes anzugeben, bei welcher die aus dem Stand der Technik bekannten Nachteile zumindest teilweise behoben sind, und welche sich insbesondere durch einerseits eine einfache und nachträgliche Montageoption und andererseits eine Verhinderung von Zerstörungen durch unbedachtes Aushängen des Ausziehelementes zu gewährleisten. Weiterhin soll ein gegenüber dem Stand der Technik verbessertes Möbel mit wenigstens einem einer Schublade gleichenden Ausziehelement und wenigstens einer Vorrichtung zur Führung eines Stromkabels entlang einer Bewegungsrichtung des wenigstens einen Ausziehelementes angegeben werden, welches sich insbesondere durch eine platzsparende Bauweise auszeichnet.

Diese Aufgabe wird durch die Merkmale des Anspruchs 1 gelöst.

Gemäß einem ersten Aspekt der Erfindung ist es vorgesehen, dass die Vorrichtung wenigstens ein Stromkabel und wenigstens eine, vorzugsweise linear bewegliche, Kabelführung für das wenigstens eine Stromkabel umfasst, wobei mindestens eine lösbare Steckverbindung vorgesehen ist, über welche das wenigstens eine Stromkabel mit einer stationären Stromversorgungseinrichtung oder einer im oder am Ausziehelement angeordneten Energieentnahmestation in elektrisch leitenden Kontakt bringbar ist, vorzugsweise wobei eine erste lösbare Steckverbindung vorgesehen ist, über welche das wenigstens eine Stromkabel mit einer stationären Stromversorgungseinrichtung in elektrisch leitenden Kontakt bringbar ist und eine zweite lösbare Steckverbindung, über welche das wenigstens eine Stromkabel mit einer im oder am Ausziehelement angeordneten Energieentnahmestation in elektrisch leitenden Kontakt bringbar ist.

Gemäß einem zweiten Aspekt der Erfindung ist es vorgesehen, dass die Vorrichtung mindestens eine lösbare Steckverbindung umfasst, wobei die Vorrichtung oder die Steckverbindung dazu vorgesehen ist, nach der Koppelung mit einer stationären Stromversorgungseinrichtung und vor dem Münden in einer Energieentnahmestation im beweglichen Ausziehelement, platziert zu werden, und wobei erfindungsgemäß eine, vorzugsweise linear bewegliche, Kabelführung mit Halteelementen und mindestens einer lösbaren Steckverbindung vorgesehen ist, wobei ein erstes Halteelement lösbar haftend, an einer Unterseite der Korpusschiene befestigt oder befestigbar sind.

Gemäß diesen beiden Aspekten kann die Vorrichtung in einfacher Weise montiert und auch in bestehenden Systemen nachgerüstet werden. Außerdem reduziert sich durch die mindestens eine lösbare Steckverbindung und die gemäß der Erfindung vorgesehene lösbar haftende Befestigung der Halteelemente und vorzugsweise der Steckverbindungen die Gefahr einer Zerstörung der Vorrichtung im Falle eines unbedachten Aushängens des Ausziehelementes, da sich im Überlastfall die mindestens eine Steckverbindung und/oder die Befestigung der Halteelemente und/oder Steckverbindungen löst.

Eine gemäß einer vorteilhaften Ausführungsform ausgestaltete Stromzuführung für Schubladen und ähnliche linear bewegbare Ausziehelemente besteht im Wesentlichen aus einer befüllten Kabelkette, an deren Enden geeignete schubladenführungsspezifische Halteelemente befestigt sind, welche jeweils über Steckerverbindungen an beiden Enden des Kabels verfügen.

Es hat sich als vorteilhaft erwiesen, dass wenigstens eine Schubladenführung, vorzugsweise eine Unterflurschubladenführung, vorgesehen ist. Unabhängig davon, ob es sich bei einer Schubladenführung um einen Teil- oder Vollauszug handelt, besteht die Führungsgarnitur mindestens aus einer fest am Korpus montierten Korpusschiene und einer beweglich geführten Ladenschiene. Bei älteren Rollenführungssystemen ist die Ladenschiene fest am Ausziehelement montiert. Derartige Schubladenführungen sind nur eingeschränkt für die Anwendung der Erfindung geeignet. In ihren Standardausführungen stellen sie den Bauraum für die Kabelkette unter dem Ausziehelement nicht zur Verfügung.

Bevorzugtes Anwendungsgebiet sind die neueren Unterflurschubladenführungen. Bei diesen Systemen sind die fest montierten und die beweglichen Führungsschienen miteinander verbunden und somit untrennbar am Korpus befestigt. Um ein Aushängen der Schublade zu ermöglichen, wird die Verbindung zwischen Ladenschiene und Schublade gelöst. Alle Führungsteile verbleiben am Möbelkorpus. Die Schublade selbst ist im ausgehängten Zustand in beinahe allen Fällen frei von Führungsschienen.

Es kann vorgesehen sein, dass ein Zuleitungskabel die elektrische Energie von der Versorgung her zum ersten Halteelement führt und dort mit einer Steckbuchse, an welcher der Stecker des ersten Halteelementes ansteckt, endet. Unabhängig von der Art des Ausziehelementes wird bei einer bevorzugten Stromzufuhr das erste Halteelement mit der fest montierten Korpusschiene haftend verbunden. An diesem ersten Halteelement beginnt die bewegliche Kabelverbindung mit einem am ersten Halteelement befestigten Stecker und führt von dieser ortsfesten Stelle via Kabelkette zum zweiten Halteelement, welches wiederum haftend an der linear beweglichen Ladenschiene befestigt ist. An diesem zweiten Halteelement mündet das bewegliche Kabel in einer am zweiten Halteelement befestigten Steckbuchse. An dieser Stelle wird bei sachgemäßem Aushängen der Schublade die Stromzufuhr zur Schublade selbst getrennt. Beide Haltelemente und die Kabelkette bleiben dann mit den Schubladenführungen verbunden.

Bei einem als Schublade ausgebildeten Ausziehelement kann an der Schublade selbst, beispielsweise in deren Rückwand, eine Steckdose montiert sein, welche selbst wiederum über eine Zuleitung mit Stecker verfügt, der von der am zweiten Halteelement befestigten Buchse aufgenommen wird. Die Wahl der jeweiligen Steckervarianten wird von den elektrischen Daten des zu übertragenden Stromes geprägt. Eine Vielzahl von weit verbreiteten Typen steht zur Auswahl. An der in der Schublade fest montierten Steckdose wird das eigentliche Gerät angesteckt.

In einer bevorzugten Ausführungsweise bieten sich für die haftende Verbindung Magnete an, da die Schubladenschienen vorzugsweise aus Stahl gefertigt sind. Bei unsachgemäßem Aushängen der Schublade, also wenn der Benutzer vergessen hat, die Steckverbindung zwischen Schublade und zweitem Halteelement rechtzeitig zu lösen, kann die Kabelkette der Bewegung der Schublade nicht mehr folgen. In diesem Fall löst sich die haftende Verbindung des zweiten Haltelementes, bevor es zu einer Zerstörung der Kabelkette kommt. Bei weiterer unsachgemäßer Behandlung löst sich auch noch das erste Halteelement von seiner Position an der festen Korpusschiene ab. Letztlich könnten auch noch die Steckverbindungen des Zuleitungskabels oder jene der Schubladensteckdose auseinandergezogen werden. Wesentlich ist, dass die unqualifizierte Behandlung der Vorrichtung keine Zerstörung der Komponenten nach sich zieht.

Technisch gesehen ist es empfehlenswert, Leitungen mit hohem Energietransfer von schnellen Datenleitungen und sensiblen Signalleitungen räumlich zu trennen. Da die Vorrichtung gemäß einer bevorzugten Ausführungsform mit zwei Schubladenführungen jeweils nur an einer der beiden Schubladenführungen platziert ist, kann zusätzlich eine zweite sinngleiche Vorrichtung an der gegenüberliegenden Schubladenführung platziert werden. So ist es möglich, ein Ausziehelement mit zweierlei Medien zu versorgen. Naheliegend ist, dass das Ausziehelement anstatt mit elektrischer Energie auch mit Flüssigkeiten oder Gasen in gleicher Weise versorgt werden kann.

Wie eingangs ausgeführt, wird Schutz auch begehrt für ein Möbel mit wenigstens einem einer Schublade gleichenden Ausziehelement und wenigstens einer Vorrichtung zur Führung eines Stromkabels entlang einer Bewegungsrichtung des wenigstens einen Ausziehelementes, wobei im oder am wenigstens einen Ausziehelement, vorzugsweise an einer Rückwand des wenigstens einen Ausziehelements, wenigstens eine Energieentnahmestation angeordnet ist, das wenigstens eine Ausziehelement einen Boden aufweist und die wenigstens eine Vorrichtung zur Führung eines Stromkabels wenigstens ein Stromkabel aufweist, und wobei zumindest das wenigstens eine Stromkabel zum überwiegenden Teil unterhalb des Bodens des wenigstens einen Ausziehelements angeordnet ist. Auf diese Weise lässt sich das wenigstens eine Stromkabel platzsparend anordnen, ohne dass hierfür weiterer Bauraum im Möbelkorpus bereitgestellt werden muss, welcher bei der Konzeption des wenigstens einen Ausziehelementes verloren gehen würde.

Weitere bevorzugte Ausführungsformen, die allein oder in Kombination miteinander realisierbar sind, sind in den abhängigen Ansprüchen definiert.

Weitere Einzelheiten und Vorteile der Erfindung werden anhand der Figurenbeschreibung unter Bezugnahme auf die Zeichnungen im Folgenden näher erläutert. Darin zeigen:
- Fig. 1: eine schematische Darstellung einer Unterflurschubladenführung,
- Fig. 2: eine schematische Darstellung der Unterseite der Unterflurschubladenführung,
- Fig. 3: Systemkomponenten eines bevorzugten Ausführungsbeispiels der Vorrichtung und deren relative Anordnung zueinander,
- Fig. 4: eine Darstellung einer montierten Vorrichtung gemäß einem weiteren bevorzugten Ausführungsbeispiel,
- Fig. 5: eine teilweise Darstellung einer Schubladenrückseite mit einem Teil einer Vorrichtung gemäß einem weiteren bevorzugten Ausführungsbeispiel, und
- Fig. 6: ein schematisch dargestelltes Möbel gemäß einem bevorzugten Ausführungsbeispiel in einer Querschnittsansicht von oben.

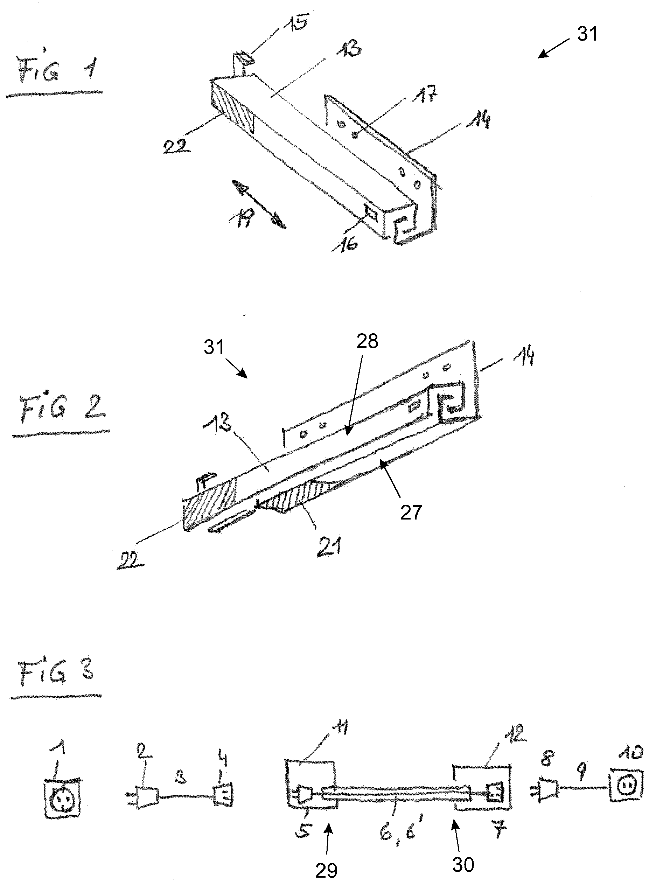

Die Figur 1 zeigt eine rechte Unterflurschubladenführung 31 umfassend eine Korpusschiene 14 und eine Ladenschiene 13. Zwischen der Korpusschiene 14 und der Ladenschiene 13 kann eine Mittelschiene angeordnet sein. Die sinngemäß dargestellten Bohrungen 17 dienen der Befestigung der Korpusschiene 14 z.B. an einer Schrankseite mittels Schrauben.

An der linear beweglichen Ladenschiene 13 kann im hinteren Bereich ein Einhängehaken 15 vorgesehen sein, welcher in ein Sackloch in einer Rückwand 25 einer Schublade 32 eingreifen und somit der Fixierung der Schublade 32 dienen kann. Das zweite Halteelement 12 (vergleiche die nachfolgenden Figuren) könnte zusätzlich zu einer haftenden Fixierung ebenfalls in diesen Haken 15 eingreifen, und bei unsachgemäßer Entnahme der Schublade 32 ebenfalls in der Bewegungsrichtung 19 vom Haken 15 abgezogen werden.

Die Schublade 32 kann über Kupplungselemente verfügen, die mit der Ladenschiene 13 kommunizieren. Diese Kupplungselemente sind normalerweise zwecks guter Erreichbarkeit nahe der Front unter dem Ladenboden 26 positioniert. Beim Betätigen der Kupplungen verlässt beispielsweise ein Sperrriegel eine Ausnehmung 16 und ermöglicht somit ein Ausziehen der Schublade 32 in Bewegungsrichtung 19 über den begrenzten Funktionsweg hinaus.

Am hinteren Ende der Ladenschiene 13 ist bevorzugt eine zweite Haftzone 22 für das zweite Halteelement 12 mit Schraffur gekennzeichnet.

Ebenfalls angezeigt ist die lineare Bewegungsrichtung 19 der Schubladenführung, welche auch der Entnahmerichtung der Schublade entspricht.

Die Figur 2 zeigt die Unterseite 27 der gleichen Schubladenführung 31 bestehend aus Korpusschine 14 und der Ladenschiene 13. Neben der bevorzugten zweiten an einem Vertikalsteg 28 der Ladenschiene 13 angeordneten Haftzone 22 für das zweite Halteelement 12 ist in dieser Darstellung auch eine bevorzugte erste Haftzone 21 für das erste Halteelement 11 ersichtlich und mit Schraffur gekennzeichnet.

Die Figur 3 vermittelt einen Überblick bezüglich der Anordnung und der Reihenfolge der Steckverbinder und Kabel, beginnend mit einer als Versorgungssteckdose ausgebildeten stationären Stromversorgungseinrichtung 1, welche das gesamte System speist. Als zweite Gruppe ist die Zuleitung mit einem Zuleitungsstecker 2, einem Zuleitungskabel 3 und einer Zuleitungsbuchse 4 schematisch dargestellt. Nachfolgend ist eine Kettengruppe angeordnet. Sie beginnt mit einem ersten Halteelement 11, an welchem ein Kettenstecker 5 eines Kettenkabels 6'montiert ist. Am ersten Halteelement 11 ist auch ein vordere Ende 29 einer Kabelführung 6 mit einer Kabelkette 34, welche das Kettenkabel 6'aufnimmt und führt, befestigt. Ein hinteres Ende 30 der Kabelführung 6 ist am zweiten Halteelement 12 befestigt. Ebenso ist eine Kettensteckbuchse 7 des Kettenkabels 6'am zweiten Halteelement 12 befestigt. Die abschließende Gruppe bildet ein der Schublade 32 zugeordnetes Ladenkabel 9, beginnend mit einem Ladenstecker 8 und endend in einer als Schubladensteckdose ausgebildeten Energieentnahmestation 10.

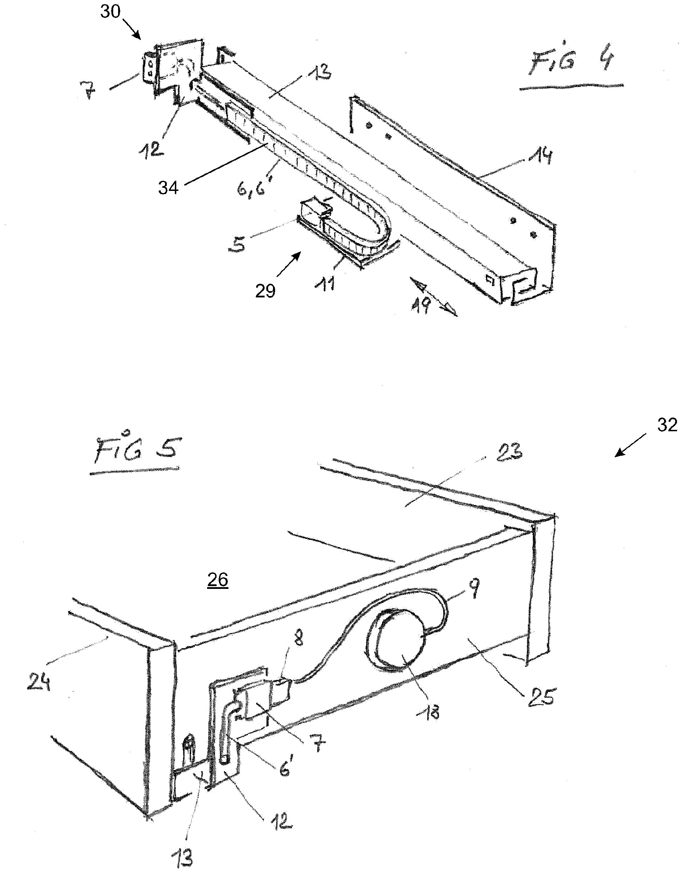

Die Figur 4 zeigt Elemente der Vorrichtung, welche an der Schubladenführung 31 montiert sind. An der Ladenschiene 13 ist von unten her haftend das erste Haltelement 11 positioniert. Beginnend mit dem darauf fixierten Kettenstecker 5 führt die Kabelkette 34 mit dem in ihr liegenden Kettenkabel 6' zum zweiten Haltelement 12, welches vorzugsweise in einem hinteren Bereich der Ladenschiene 13 anhaftet. Das Kettenkabel 6'mündet an einer Kettensteckbuchse 7, welche ebenfalls am zweiten Halteelement 12 fixiert ist. Es ist naheliegend, dass der Verlauf der Kabelführung 6 oder der Kabelkette 34 auch spiegelverkehrt gewählt werden kann. Dargestellt ist auch die Bewegungsrichtung 19.

Es bietet sich an, dass eine erste lösbare Steckverbindung 4, 5 vorgesehen ist, über welche das Stromkabel 6' mit einer stationären Stromversorgungseinrichtung 1 in elektrisch leitenden Kontakt bringbar ist und eine zweite lösbare Steckverbindung 7, 8, über welche das Stromkabel 6' mit einer im oder am Ausziehelement 32 angeordneten Energieentnahmestation 10 in elektrisch leitenden Kontakt bringbar ist, wobei die beiden Steckverbindungen 4, 5, 7, 8 in einer ersten Position des Ausziehelements 32, welche einer Schließstellung des Ausziehelementes 32 entspricht, bezogen auf die Bewegungsrichtung 19 in einer ersten Reihenfolge hintereinander angeordnet sind und in einer zweiten Position des Ausziehelementes 32, welche einer maximalen Offenstellung des Ausziehelementes (32) entspricht, bezogen auf die Bewegungsrichtung 19 in einer zweiten, der ersten Reihenfolge umgekehrten Reihenfolge hintereinander angeordnet sind. Die Figur 4 zeigt dabei die Schließstellung eines Ausziehelementes 32 (nicht dargestellt), wenn es an der Schubladenführung 31 angeordnet wäre.

Ein erstes Ende 29 des Stromkabels 6' ist im Wesentlichen parallel zur Bewegungsrichtung 19 und ein zweites Ende 30 des Stromkabels 6' im Wesentlichen quer zur Bewegungsrichtung 19 des Ausziehelements 2 angeordnet.

Die Figur 5 zeigt einen Teil eines als Schublade ausgebildeten Ausziehelementes 32 von hinten, wobei die rechte Schubladenseite 23, die linke Schubladenseite 24, die Rückwand 25 und ein Boden 26 schematisch dargestellt sind. Ebenso sind die rechte Ladenschiene 13 mit anhaftendem zweitem Halteelement 12 und das Kettenkabel 6' mündend in der Kettensteckbuchse 7 dargestellt. Im Mittelfeld der Rückwand 25 durchdringt eine Hohlwanddose 18, in der von vorne eine Ladensteckdose 10 montiert und zugänglich ist. Das mit der Ladensteckdose 10 verbundene ebenfalls dargestellte Ladenkabel 9 verfügt vorzugsweise über Längenreserve, bevor es im Ladenstecker 8 mündet. Die Längenreserve erleichtert das Trennen des Ladensteckers 8 von der Kettensteckbuchse 7 im Zuge einer sachgemäßen Entnahme der Schublade und verhindert ein vorzeitiges Lösen der Haftelemente 11 und 12.

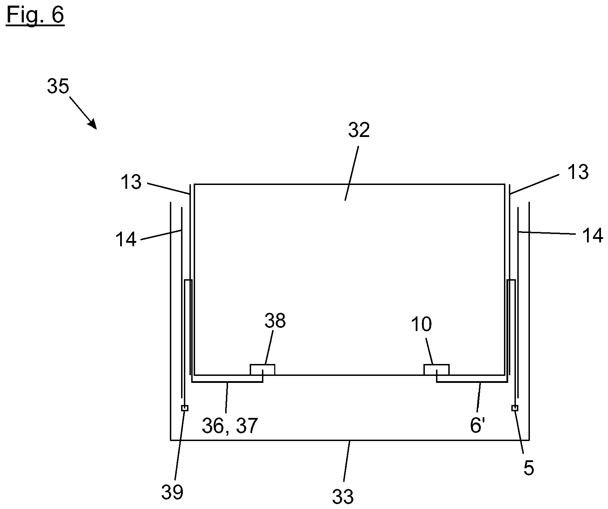

Die Figur 6 zeigt ein Möbel 35 mit einem einer Schublade gleichenden Ausziehelement 32, welches über zwei voneinander beabstandete Schubladenführungen 31 an einem Möbelkorpus 33 des Möbels 35 bewegbar gelagert ist. Es ist eine Vorrichtung zur Führung eines Stromkabels 6' entlang einer Bewegungsrichtung 19 des Ausziehelementes 32 vorgesehen, wobei im oder am Ausziehelement 32, vorzugsweise an einer Rückwand 25 des Ausziehelements 32, wenigstens eine Energieentnahmestation 10 angeordnet ist. Das Ausziehelement 32 weist einen Boden 26 auf. Die Vorrichtung zur Führung eines Stromkabels 6' weist wenigstens ein Stromkabel 6' aufweist, welches zum überwiegenden Teil unterhalb des Bodens 26 des wenigstens einen Ausziehelements 32 angeordnet ist. In der Figur 5 ist das wenigstens eine Stromkabel 6` aus Gründen der Übersichtlichkeit neben dem Boden 26 dargestellt.

Das wenigstens eine Stromkabel 6' ist im Betriebszustand ständig mit der wenigstens einen Energieentnahmestation 10 verbunden.

Es kann wie im dargestellten Ausführungsbeispiel vorgesehen sein, dass an einer ersten Seite des Ausziehelements 32 die Vorrichtung zur Führung eines Stromkabels 6' und auf einer zweiten Seite des Ausziehelements 32 eine Vorrichtung zur Führung einer Signalleitung 36 und/oder einer Fluidleitung 37 angeordnet ist, wobei die Vorrichtungen sinngleich ausgebildet sind. Die Vorrichtung zur Führung einer Signalleitung 36 und/oder einer Fluidleitung 37 kann insbesondere eine Entnahmestation 38 für das Signal und/oder das Fluid und/oder eine Kopplung 39 zur Koppelung der Signalleitung 36 oder der Fluidleitung 37 mit einer Signalquelle oder einer Fluidquelle umfassen.

### Bezugszeichenliste

- 1: stationären Stromversorgungseinrichtung, vzw. Versorgungssteckdose
- 2: Zuleitungsstecker
- 3: Zuleitungskabel
- 4: lösbare Steckverbindung, vzw. Zuleitungsbuchse
- 5: lösbare Steckverbindung, vzw. Kettenstecker
- 6: Kabelführung, vzw. Kabelkette
- 6': Stromkabel, vzw. Kettenkabel
- 7: lösbare Steckverbindung, vzw. Kettensteckbuchse
- 8: lösbare Steckverbindung, vzw. Ladenkabelstecker
- 9: Ladenkabel
- 10: Energieentnahmestation, vzw. Ladensteckdose
- 11: erstes Halteelement
- 12: zweites Halteelement
- 13: Ladenschiene
- 14: Korpusschiene
- 15: Einhängehaken
- 16: Kupplungeingriff
- 17: Montagebohrungen
- 18: Hohlwanddose
- 19: Bewegungsrichtung
- 21: erste Haftzone
- 22: zweite Haftzone
- 23: linke Schubladenseite
- 24: rechte Schubladenseite
- 25: Schubladenrückwand
- 26: Boden
- 27: Unterseite
- 28: Vertikalsteg
- 29: erstes Ende
- 30: zweites Ende
- 31: Schubladenführung
- 32: Ausziehelement
- 33: Möbelkorpus
- 34: Kabelkette
- 35: Möbel
- 36: Signalleitung
- 37: Fluidleitung
- 38: Entnahmestation
- 39: Kopplung

## Patentansprüche

1. Vorrichtung zur Führung eines Stromkabels (6') entlang einer Bewegungsrichtung (19) eines einer Schublade gleichenden Ausziehelementes (32), mit wenigstens einem Stromkabel (6`) und wenigstens einer, vorzugsweise linear beweglichen, Kabelführung (6) für das wenigstens eine Stromkabel (6`), wobei mindestens eine lösbare Steckverbindung (4, 5, 7, 8) vorgesehen ist, über welche das wenigstens eine Stromkabel (6') mit einer stationären Stromversorgungseinrichtung (1) oder einer im oder am Ausziehelement (32) angeordneten Energieentnahmestation (10) in elektrisch leitenden Kontakt bringbar ist, vorzugsweise wobei eine erste lösbare Steckverbindung (4, 5) vorgesehen ist, über welche das wenigstens eine Stromkabel (6') mit einer stationären Stromversorgungseinrichtung (1) in elektrisch leitenden Kontakt bringbar ist und eine zweite lösbare Steckverbindung (7, 8), über welche das wenigstens eine Stromkabel (6') mit einer im oder am Ausziehelement (32) angeordneten Energieentnahmestation (10) in elektrisch leitenden Kontakt bringbar ist, **dadurch gekennzeichnet, dass** wenigstens eine als Unterflurschubladenführung ausgebildete Schubladenführung (31) vorgesehen ist, wobei die wenigstens eine Schubladenführung (31) eine an einem Möbelkorpus (33) zu montierende Korpusschiene (14) aufweist und ein erstes Halteelement (11) der Kabelführung (6) lösbar haftend an einer Unterseite (27) der Korpusschiene (14) befestigt oder befestigbar ist, vorzugsweise wobei die lösbare Befestigung wenigstens eine Magnetverbindung umfasst.

2. Vorrichtung nach Anspruch 1, **dadurch gekennzeichnet, dass** die mindestens eine lösbare Steckverbindung (4, 5, 7, 8) dazu vorgesehen ist, nach der Koppelung mit der stationären Stromversorgungseinrichtung (1) und vor dem Münden in der Energieentnahmestation (10) im beweglichen Ausziehelement (32) platziert zu werden, wobei eine, vorzugsweise linear bewegliche, Kabelführung (6) mit Halteelementen (11, 12) und Steckverbindungen (5, 7) vorgesehen ist, wobei die Halteelemente (11, 12) und/oder Steckverbindungen (5, 7) der Kabelführung (6) lösbar, vorzugsweise haftend, befestigt oder befestigbar sind.

3. Vorrichtung nach Anspruch 1 oder 2, wobei nach der Kabelführung (6) dem Ausziehelement (32) zugewandt eine lösbare Steckverbindung (7, 8) vorhanden ist.

4. Vorrichtung nach einem der Ansprüche 1 bis 3, wobei die wenigstens eine Schubladenführung (31) eine mit dem Ausziehelement (32) zu verbindende Ladenschiene (13) aufweist und ein zweites Halteelement (12) der Kabelführung (6) lösbar, vorzugsweise haftend, an der Ladenschiene (13), vorzugsweise an einem Vertikalsteg (28) der Ladenschiene (13), und/oder lösbar, vorzugsweise haftend, am Ausziehelement (32) befestigt oder befestigbar ist, vorzugsweise wobei die lösbare Befestigung wenigstens eine Magnetverbindung umfasst.

5. Vorrichtung nach Anspruch 4, wobei die Ladenschiene (13) einen Einhängehaken (15) aufweist und das zweite Halteelemente (12) in den Einhängehaken (15) der Ladenschiene (13) eingreift.

6. Vorrichtung nach einem der Ansprüche 1 bis 5, wobei die Kabelführung (6) wenigstens eine Kabelkette (34) aufweist, in welcher das wenigstens eine Stromkabel (6') zumindest bereichsweise angeordnet ist.

7. Vorrichtung nach einem der Ansprüche 1 bis 6, wobei an wenigstens einem Ende (29, 30), besonders bevorzugt an beiden Enden (29, 30), des wenigstens einen Stromkabels (6') ein lösbare Steckerverbindung (4, 5, 7, 8) angeordnet ist.

8. Vorrichtung nach einem der Ansprüche 1 bis 7, wobei das wenigstens eine Stromkabel (6') ein erstes Ende (29) und ein zweites Ende (30) aufweist, wobei ein erstes Halteelement (11) vorgesehen ist, an welchem das erste Ende (29) des Stromkabels (6') befestigt ist, und ein zweites Halteelement (12), an welchem das zweite Ende (30) des Stromkabels (6') befestigt ist.

9. Vorrichtung nach einem der Ansprüche 1 bis 8, wobei eine erste lösbare Steckverbindung (4, 5) vorgesehen ist, über welche das wenigstens eine Stromkabel (6') mit einer stationären Stromversorgungseinrichtung (1) in elektrisch leitenden Kontakt bringbar ist und eine zweite lösbare Steckverbindung (7, 8), über welche das wenigstens eine Stromkabel (6') mit einer im oder am Ausziehelement (32) angeordneten Energieentnahmestation (10) in elektrisch leitenden Kontakt bringbar ist, wobei die beiden Steckverbindungen (4, 5, 7, 8) in einer ersten Position des wenigstens einen Ausziehelementes (32), welche einer Schließstellung des wenigstens einen Ausziehelementes (32) entspricht, bezogen auf die Bewegungsrichtung (19) in einer ersten Reihenfolge hintereinander angeordnet sind und in einer zweiten Position des wenigstens einen Ausziehelementes (32), welche einer maximalen Offenstellung des wenigstens einen Ausziehelementes (32) entspricht, bezogen auf die Bewegungsrichtung (19) in einer zweiten, der ersten Reihenfolge umgekehrten Reihenfolge hintereinander angeordnet sind.

10. Vorrichtung nach einem der Ansprüche 1 bis 9, wobei ein erstes Ende (29) des wenigstens einen Stromkabels (6`) im Wesentlichen parallel zur Bewegungsrichtung (19) und/oder ein zweites Ende (30) des wenigstens einen Stromkabels (6') im Wesentlichen quer zur Bewegungsrichtung (19) des wenigstens einen Ausziehelements (2) angeordnet ist.

11. Möbel (35) mit wenigstens einem einer Schublade gleichenden Ausziehelement (32) und wenigstens einer Vorrichtung zur Führung eines Stromkabels (6') entlang einer Bewegungsrichtung (19) des wenigstens einen Ausziehelementes (32), wobei die wenigstens eine Vorrichtung gemäß einem der vorhergehenden Ansprüche ausgebildet ist, wobei im oder am wenigstens einen Ausziehelement (32), vorzugsweise an einer Rückwand (25) des wenigstens einen Ausziehelements (32), wenigstens eine Energieentnahmestation (10) angeordnet ist, das wenigstens eine Ausziehelement (32) einen Boden (26) aufweist, **dadurch gekennzeichnet, dass** zumindest das wenigstens eine Stromkabel (6') zum überwiegenden Teil unterhalb des Bodens (26) des wenigstens einen Ausziehelements (32) angeordnet ist.

12. Möbel (35) nach Anspruch 11, wobei das Möbel (35) einen Möbelkorpus (33) aufweist und wenigstens eine, vorzugsweise zwei, Schubladenführung (31), vorzugsweise eine Unterflurschubladenführung, vorgesehen ist, über welche das wenigstens eine Ausziehelement (32) am Möbelkorpus (33) bewegbar gelagert ist, wobei die wenigstens eine Schubladenführung (31) eine an einem Möbelkorpus (33) montierte Korpusschiene (14) und eine mit dem Ausziehelement (32) verbundene oder verbindbare Ladenschiene (13) aufweist.

13. Möbel (35) nach Anspruch 11 oder 12, wobei das wenigstens eine Stromkabel (6`) im Betriebszustand ständig mit der wenigstens einen Energieentnahmestation (10) verbunden ist.

14. Möbel (35) nach einem der Ansprüche 11 bis 13, wobei wenigstens ein Zuleitungskabel (3) vorgesehen ist, welches das wenigstens eine Stromkabel (6') im Betriebszustand elektrisch leitend mit einer stationären Stromversorgungseinrichtung (1) verbindet.

15. Möbel (35) nach einem der Ansprüche 11 bis 14, wobei auf einer ersten Seite des wenigstens einen Ausziehelements (32) die wenigstens eine Vorrichtung zur Führung eines Stromkabels (6') und auf einer zweiten Seite des wenigstens einen Ausziehelements (32) eine Vorrichtung zur Führung einer Signalleitung (36) und/oder einer Fluidleitung (37) angeordnet ist.

## Claims

1. A device for guiding a power cable (6') along a movement direction (19) of a pull-out element (32) resembling a drawer, comprising at least one power cable (6') and at least one, preferably linearly movable, cable guide (6) for the at least one power cable (6'), wherein at least one releasable plug-in connection (4, 5, 7, 8) is provided, via which the at least one power cable (6') can be brought into electrically conductive contact with a stationary power supply device (1) or with an energy withdrawal station (10) arranged in or on the pull-out element (32), preferably wherein a first releasable plug-in connection (4, 5) is provided, via which the at least one power cable (6') can be brought into electrically conductive contact with a stationary power supply device (1), and a second releasable plug-in connection (7, 8), via which the at least one power cable (6') can be brought into electrically conductive contact with an energy withdrawal station (10) arranged in or on the pull-out element (32), **characterized in that** at least one drawer guide (31) in the form of an undermount drawer guide is provided, the at least one drawer guide (31) having a carcass rail (14) configured to be fixed to a furniture carcass (33), and a first retaining element (11) of the cable guide (6) is fixed or can be fixed to an underside (27) of the carcass rail (14) in a releasably adherent manner, preferably wherein the releasable fixing includes at least one magnetic connection.

2. The device according to claim 1, **characterized in that** at least one releasable plug-in connection (4, 5, 7, 8) is configured to be placed, after the coupling to the stationary power supply device (1) and before leading to the energy withdrawal station (10), in the movable pull-out element (32), wherein a, preferably linearly movable, cable guide (6) with retaining elements (11, 12) and plug-in connections (5, 7) are provided, wherein the retaining elements (11, 12) and/or plug-in connections (5, 7) of the cable guide (6) are, preferably adherently, fixed or can be fixed.

3. The device according to claim 1 or 2, wherein after the cable guide (6), a releasable plug-in connection (7, 8) facing towards the pull-out element (32) is provided.

4. The device according to one of the claims 1 to 3, wherein at least one drawer guide (31) includes a drawer rail (13) configured to be connected to the pull-out element (32), wherein a second retaining element (12) of the cable guide (6) is or can be releasably, preferably adherently, fixed to the drawer rail (13), preferably to a vertical limb (28) of the drawer rail (13), and/or is or can be releasably, preferably adherently, fixed to the pull-out element (32), preferably wherein the releasable fixing comprises at least one magnetic connection.

5. The device according to claim 4, wherein the drawer rail (13) includes an engagement hook (15), and the second retaining element (12) engages in the engagement hook (15) of the drawer rail (13).

6. The device according to one of the claims 1 to 5, wherein the cable guide (6) includes at least one cable chain (34) in which the at least one power cable (6') is at least partially arranged.

7. The device according to one of the claims 1 to 6, wherein a releasable plug connection (4, 5, 7, 8) is arranged on at least one end (29, 30), preferably on both ends (29, 30), of the at least one power cable (6').

8. The device according to one of the claims 1 to 7, wherein the at least one power cable (6') has a first end (29) and a second end (30), wherein a first retaining element (11) is provided, to which the first end (29) of the power cable (6`) is fixed, and a second retaining element (12), to which the second end (30) of the power cable (6') is fixed.

9. The device according to one of claims 1 to 8, wherein a first releasable plug-in connection (4, 5) is provided, via which the at least one power cable (6') can be brought into electrically conductive contact with a stationary power supply device (1), and a second releasable plug-in connection (7, 8), via which the at least one power cable (6') can be brought into electrically conductive contact with an energy withdrawal station (10) arranged in or on the pull-out element (32), wherein the two plug-in connections (4, 5, 7, 8), in a first position of the at least one pull-out element (32) corresponding to a closed position of the at least one pull-out element (32), are arranged one behind the other relative to the movement direction (19) in a first sequence and, in a second position of the at least one pull-out element (32) corresponding to a maximum open position of the at least one pull-out element (32), are arranged one behind the other in a second sequence relative to the movement direction (19), the second sequence being reverse to the first sequence.

10. The device according to one of claims 1 to 9, wherein a first end (29) of the at least one power cable (6') is arranged substantially parallel to the movement direction (19) and/or a second end (30) of the at least one power cable (6') is arranged substantially transversely to the movement direction (19) of the at least one pull-out element (32).

11. A piece of furniture (35) comprising at least one pull-out element (32) resembling a drawer and at least one device for guiding a power cable (6') along a movement direction (19) of the at least one pull-out element (32), wherein the at least one device is formed according to one of the preceding claims, wherein at least one energy withdrawal station (10) is arranged in or on the at least one pull-out element (32), preferably on a rear wall (25) of the at least one pull-out element (32), the at least one pull-out element (32) including a base (26), **characterized in that** the at least one power cable (6') is predominantly arranged underneath the base (26) of the at least one pull-out element (32).

12. The piece of furniture (35) according to claim 11, wherein the piece of furniture (35) includes a furniture carcass (33), and at least one, preferably two, drawer guides (31), preferably an undermount drawer guide, is provided, via which the at least one pull-out element (32) is movably mounted on the furniture carcass (33), wherein the at least one drawer guide (31) includes a carcass rail (14) fixed to a furniture carcass (33) and a drawer rail (13) which is connected or which can be connected to the pull-out element (32).

13. The piece of furniture (35) according to claim 11 or 12, wherein the at least one power cable (6') is permanently connected to the at least one energy withdrawal station (10) in the operating state.

14. The piece of furniture (35) according to one of the claims 11 to 13, wherein at least one supply cable (3) is provided, which connects the at least one power cable (6') in an electrically conductive manner to a stationary power supply device (1) in the operating state.

15. The piece of furniture (35) according to one of the claims 11 to 14, wherein the at least one device for guiding a power cable (6') is arranged on a first side of the at least one pull-out element (32), and a device for guiding a signal line (36) and/or a fluid line (37) is arranged on a second side of the at least one pull-out element (32).

## Revendications

1. Dispositif de guidage d'un câble électrique (6') le long d'une direction de déplacement (19) d'un élément d'extraction (32) similaire à un tiroir, avec au moins un câble électrique (6') et au moins un guide-câble (6) de préférence mobile linéairement pour l'au moins un câble électrique (6'), dans lequel au moins un raccord enfichable (4, 5, 7, 8) amovible est prévu, par l'intermédiaire duquel l'au moins un câble électrique (6') peut être amené en contact électriquement conducteur avec un système d'alimentation électrique stationnaire (1) ou une station de prélèvement d'énergie (10) disposée dans ou sur l'élément d'extraction (32), de préférence dans lequel sont prévus un premier raccord enfichable (4, 5) amovible, par l'intermédiaire duquel l'au moins un câble électrique (6') peut être amené en contact électriquement conducteur avec un système d'alimentation électrique (1) stationnaire, et un deuxième raccord enfichable (7, 8) amovible, par l'intermédiaire duquel l'au moins un câble électrique (6') peut être amené en contact électriquement conducteur avec une station de prélèvement d'énergie (10) disposé dans ou sur l'élément d'extraction (32), **caractérisé en ce qu'**au moins un guide-tiroir (31) réalisé en tant que guide-tiroir souterrain est prévu, dans lequel l'au moins un guide-tiroir (31) présente un rail de corps (14) à monter sur un corps de meuble (33) et un premier élément de maintien (11) du guide-câble (6) est fixé ou peut être fixé par adhérence de manière amovible sur un côté inférieur (27) du rail de corps (14), de préférence dans lequel la fixation amovible comprend au moins un raccordement magnétique.

2. Dispositif selon la revendication 1, **caractérisé en ce que** l'au moins un raccord enfichable (4, 5, 7, 8) amovible est prévu pour être placé dans l'élément d'extraction (32) mobile après le couplage au système d'alimentation électrique stationnaire (1) et avant de déboucher dans la station de prélèvement d'énergie (10), dans lequel un guide-câble (6) de préférence mobile linéairement est prévu avec des éléments de maintien (11, 12) et des raccords enfichables (5, 7), dans lequel les éléments de maintien (11, 12) et/ou les raccords enfichables (5, 7) du guide-câble (6) sont fixés ou peuvent être fixés de manière amovible, de préférence par adhérence.

3. Dispositif selon la revendication 1 ou 2, dans lequel un raccord enfichable (7, 8) amovible est présent après le guide-câble (6) de manière tournée vers l'élément d'extraction (32).

4. Dispositif selon l'une quelconque des revendications 1 à 3, dans lequel l'au moins un guide-tiroir (31) présente un rail de chargement (13) à raccorder à l'élément d'extraction (32), et un deuxième élément de maintien (12) du guide-câble (6) est fixé ou peut être fixé de manière amovible, de préférence par adhérence, sur le rail de chargement (13), de préférence sur une entretoise verticale (28) du rail de chargement (13), et/ou de manière amovible, de préférence par adhérence, sur l'élément d'extraction (32), de préférence dans lequel la fixation amovible comprend au moins un raccord magnétique.

5. Dispositif selon la revendication 4, dans lequel le rail de chargement (13) présente un crochet de suspension (15), et le deuxième élément de maintien (12) vient en prise avec le crochet de suspension (15) du rail de chargement (13).

6. Dispositif selon l'une quelconque des revendications 1 à 5, dans lequel le guide-câble (6) présente au moins une chaîne-câble (34), dans laquelle l'au moins un câble électrique (6') est disposé au moins par endroits.

7. Dispositif selon l'une quelconque des revendications 1 à 6, dans lequel un raccord enfichable (4, 5, 7, 8) amovible est disposé sur au moins une extrémité (29, 30), de manière particulièrement préférée sur les deux extrémités (29, 30) de l'au moins un câble électrique (6').

8. Dispositif selon l'une quelconque des revendications 1 à 7, dans lequel l'au moins un câble électrique (6') présente une première extrémité (29) et une deuxième extrémité (30), dans lequel sont prévus un premier élément de maintien (11), sur lequel la première extrémité (29) du câble électrique (6') est fixée, et un deuxième élément de maintien (12), sur lequel la deuxième extrémité (30) du câble électrique (6') est fixée.

9. Dispositif selon l'une quelconque des revendications 1 à 8, dans lequel sont prévus un premier raccord enfichable (4, 5) amovible, par l'intermédiaire duquel l'au moins un câble électrique (6') peut être amené en contact électriquement conducteur avec un système d'alimentation électrique stationnaire (1), et un deuxième raccord enfichable (7, 8) amovible, par l'intermédiaire duquel l'au moins un câble électrique (6') peut être amené en contact électriquement conducteur avec une station de prélèvement d'énergie (10) disposée dans ou sur l'élément d'extraction (32), dans lequel les deux raccords enfichables (4, 5, 7, 8) sont disposés l'un derrière l'autre dans un premier ordre par rapport à la direction de déplacement (19) dans une première position de l'au moins un élément d'extraction (32), lequel correspond à une position de fermeture de l'au moins un élément d'extraction (32), et sont disposés les uns derrière les autres dans un deuxième ordre contraire au premier ordre par rapport à la direction de déplacement (19) dans une deuxième position de l'au moins un élément d'extraction (32), laquelle correspond à une position d'ouverture maximale de l'au moins un élément d'extraction (32).

10. Dispositif selon l'une quelconque des revendications 1 à 9, dans lequel une première extrémité (29) de l'au moins un câble électrique (6') est disposée de manière sensiblement parallèle par rapport à la direction de déplacement (19) et/ou une deuxième extrémité (30) de l'au moins un câble électrique (6') est disposée de manière sensiblement transversale par rapport à la direction de déplacement (19) de l'au moins un élément d'extraction (2).

11. Meuble (35) avec au moins un élément d'extraction (32) similaire à un tiroir et au moins un dispositif de guidage d'un câble électrique (6') le long d'une direction de déplacement (19) de l'au moins un élément d'extraction (32), dans lequel l'au moins un dispositif est réalisé selon l'une quelconque des revendications précédentes, dans lequel au moins une station de prélèvement d'énergie (10) est disposée dans ou sur l'au moins un élément d'extraction (32), de préférence sur une paroi arrière (25) de l'au moins un élément d'extraction (32), l'au moins un élément d'extraction (32) présente un fond (26), **caractérisé en ce que** au moins l'au moins un câble électrique (6') est disposé en majeure partie sous le fond (26) de l'au moins un élément d'extraction (32).

12. Meuble (35) selon la revendication 11, dans lequel le meuble (35) présente un corps de meuble (33) et au moins un, de préférence deux guide-tiroirs (31), de préférence un guide-tiroir souterrain sont prévus, par l'intermédiaire desquels l'au moins un élément d'extraction (32) est monté de manière à pouvoir être déplacé sur le corps de meuble (33), dans lequel l'au moins un guide-tiroir (31) présente un rail de corps (14) monté sur un corps de meuble (33) et un rail de chargement (13) raccordé ou pouvant être raccordé à l'élément d'extraction (32).

13. Meuble (35) selon la revendication 11 ou 12, dans lequel l'au moins un câble électrique (6') est raccordé dans l'état de fonctionnement en permanence à l'au moins une station de prélèvement d'énergie (10).

14. Meuble (35) selon l'une quelconque des revendications 11 à 13, dans lequel au moins un câble d'arrivée (3) est prévu, lequel raccorde l'au moins un câble électrique (6') dans l'état de fonctionnement de manière électriquement conductrice à un système d'alimentation électrique (1) stationnaire.

15. Meuble (35) selon l'une quelconque des revendications 11 à 14, dans lequel l'au moins un dispositif de guidage d'un câble électrique (6') est disposé sur un premier côté de l'au moins un élément d'extraction (32), et un dispositif de guidage d'une ligne de signaux (36) et/ou d'une conduite de fluide (37) est disposé sur un deuxième côté de l'au moins un élément d'extraction (32).
